# EUROPEAN PATENT APPLICATION

(11) **EP 1 355 328 A1**
(43) Date of publication of application: **22.10.2003**
(21) Application number: 02425229.8
(22) Date of filing: 15.04.2002
(51) Int. Cl.: H01F 27/02, H01F 27/29

(54) **Support for the assembly of inductive electronic components**

(71) Applicant: Magnetek S.p.A., 52028 Terranuova Bracciolini (Arezzo) (IT)
(72) Inventor: Brocchi, Davide, 59100 Prato (IT); Canova, Antonio, 52025 Montevarchi, Arezzo (IT)
(74) Representative: Mannucci, Michele

(57) **Abstract**

An isolating material element (1) for the assembly of inductive electronic components is described. The element comprises a base (3) with two lateral appendixes (5) equipped with through-holes (7) for electric connection terminals (9) and a central through aperture (11). Furthermore, a collar (13) developing from said base and surrounding said aperture is provided.

## Description

The invention relates to an isolating material element for the assembly of inductive components, intended for use in electronic circuits, e.g. inductors, transformers or other components which require the use of a ferromagnetic core and one or more electric windings associated to the ferromagnetic core.

The so-called SMD technology is frequently used to make electronic circuits, according to which each component is temporarily fitted by a robot on an electronic board and afterwards appropriately soldered to the conductive tracks made on the board. The inductive components, typically transformers and inductors, are critical elements for this type of assembly, because they are difficult to apply to the electronic boards.

The object of the invention is to make an isolating element for the assembly of inductive electronic components which is particularly versatile permitting the creation of various types of inductive components, with ferromagnetic cores of different shapes, which can be used to make inductive electronic components which are easily assembled with SMD technology.

Essentially, the element according to the invention comprises a base which is approximately flat with two lateral appendixes equipped with through-holes for the insertion of electric connection terminals for one or more windings and a central through aperture made in the base with a collar developed around the aperture and projecting from the base. Advantageously, the collar and the corresponding through aperture in the base of the isolating element are circular.

As will appear from the description of an embodiment of the element and some possible practical applications thereof, an element of this kind can be used to make inductive electronic components of various shapes, also using substantially different ferromagnetic core configurations. Furthermore, the particular configuration of the assembly element facilitates application on electronic boards and offers considerable versatility for assembly.

According to a particularly advantageous embodiment of the invention, the lateral appendixes of the base of the element are thicker than the base from which they project and form a step on the opposite side of the base, with respect to the side from which the collar which surrounds the through-hole of the base projects.

Additional advantageous features and embodiments of the element according to the invention are set forth in the accompanying claims.

The invention also relates to an electronic inductive component comprising an isolating assembly element as described above in addition to a ferromagnetic core and at least one electric winding.

Additional advantageous features and embodiments of the electronic inductive component according to the invention are set forth in the annexed claims and some possible embodiments are described below with reference to the accompanying drawings.

The invention will be better understood following the description and the attached drawing, which shows a practical non-limitative example of the embodiment itself. In the drawing:
Fig. 1 is a side and partial axial cross-sectional view of the assembly element according to the invention,
Fig. 2 is a plan view according to II-II in Fig. 1,
Fig. 3 shows a side and partial cross-sectional view according to III-III in Fig. 2,
Fig. 4 shows the element in Figs 1 to 3 with a double planar winding made upon it,
Fig. 5 shows a plan view according to V-V in Fig. 4,
Fig. 6 shows a later phase in the making of a transformer using the element and the windings of Fig. 4,
Fig. 7 shows the complete transformer fitted on an electronic board in a first configuration,
Fig. 8 shows the transformer of Fig. 7 fitted in a different configuration,
Fig. 9 shows a lateral view and partial axial cross-sectional view of an inductive component made with the element according to the invention and a toroid ferromagnetic core and
Fig. 10 shows a plan view according to X-X in Fig. 9.

Figs from 1 to 3 show the assembly element without the remaining elements which form the inductive component. The assembly element is generally indicated by reference numeral 1. It comprises a base 3 with two lateral appendixes 5 which present, with respect to the base 3, an increased thickness, forming steps 5A on one side of the base 3.

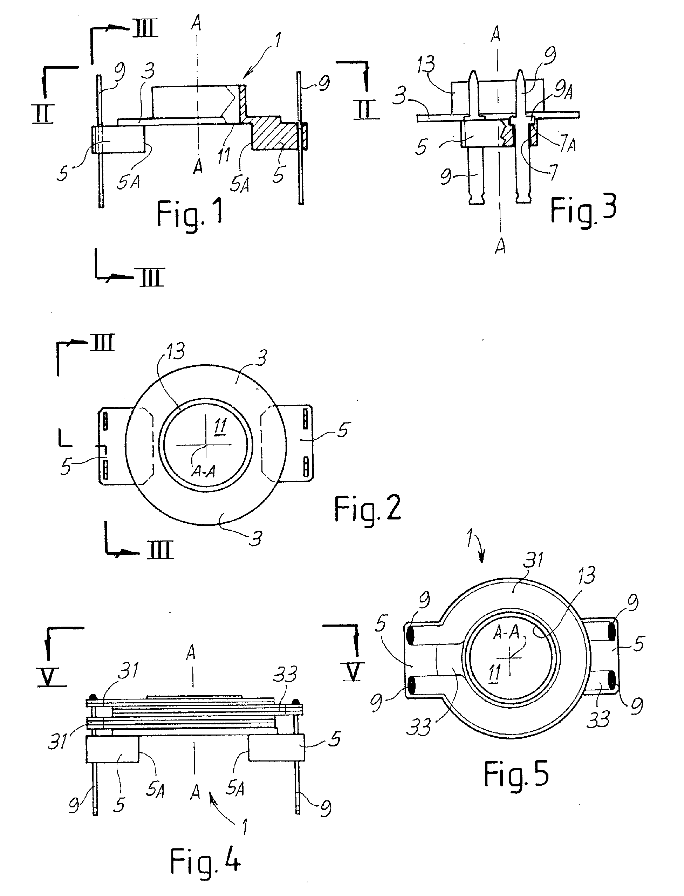

Two through-holes 7 in which corresponding electric laminar terminals 9 are inserted are developed through each of the side appendixes 5. As appears particularly in Fig. 3, each through-hole 7 presents a stop 7A, which co-operates with a corresponding ridge 9A of the respective terminal 9, whereby forming a well-defined assembly position in the through-hole 7. Each terminal 9 projects from both ends of the appendix 5 which carries it after being inserted in the respective through-hole 7.

A circular through aperture 11 is provided in the central area of the base 3. The base 3 thus assumes a conformation which is essentially annular with an external circular edge. The central through aperture 11 is surrounded by a collar 13, whose transversal cross-section is essentially circular, corresponding to the shape of the aperture 11. The collar 13 extends from the side of the base 3 opposite to the side from which the steps 5A, formed by the lateral appendixes 5, project. Line A-A indicates the axis of the cylindrical collar 13 and the through aperture 11 in the base 3.

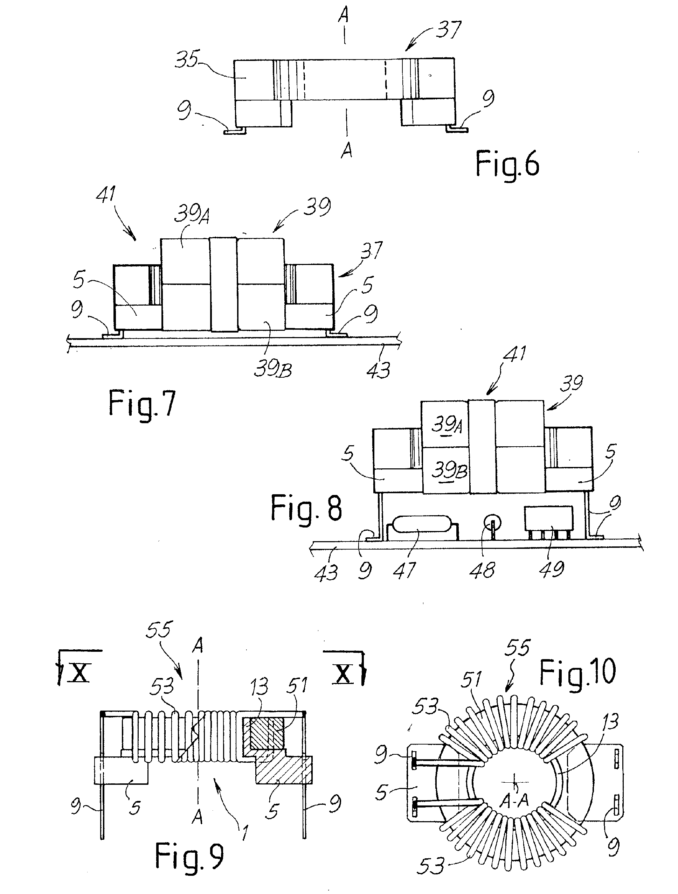

The assembly element 1 described to this point is multifunctional, i.e. can be used for making inductive electronic components of various shapes and nature. Figs from 4 to 7 show the construction and assembly phases of a planar transformer made using the element 1. In Figs 4 and 5, windings of laminar conductive material 31 and 33, which are a primary winding and a secondary winding of the transformer, are placed around the collar 13 of the element 1. The windings 31 are connected to a first pair of terminals 9 associated to one of the two appendixes 5, while the windings 33 are electrically connected to the terminals 9 associated to the other appendix 5.

Fig. 6 shows a lateral view of the assembly formed by the element 1 and the windings 31, 33, after that these have been encapsulated in a protection 35 made of plastic or resin thus forming a single resin block, generally indicated with reference numeral 37; the four terminals 9 projecting from underneath the block have been cut at the required length and bent in the form of an L to form four pins for connecting to the electronic board onto which the transformer will later be fitted. The opposite ends of the terminals 9 are embedded in the plastic which encloses the windings and the assembly element 1.

Despite the fact that, in this embodiment, the windings are planar, i.e. made of laminar conductor windings, windings made of traditional conducting wire, having a typical circular cross-section, can be formed around the collar 13. In this case, the element 1 replaces the spool on which the windings are normally formed.

The ferromagnetic core 39 is applied around the component 37. The ferromagnetic core 39 consists of two symmetric portions 39A and 39B as shown in Fig. 7. The ferromagnetic core 39 and the component 37 together form the transformer 41. The ferromagnetic core 39 presents a double E section with a central leg which crosses the through aperture 11 in the element 1 and is consequently coaxial to the axis A-A. The pins formed by the projecting and L-shaped parts of the terminals 9 are welded to the conductive tracks of the electronic board 43 on which the transformer 41 is applied.

Fig. 8 shows the same transformer 41 in a different assembly configuration. In this case, the connection terminals 9 were only bent in correspondence with their distal ends instead of being cut so that the transformer 41 is fitted at a greater distance with respect to the electronic board 43. Other electronic components, generally indicated with reference numerals 47, 48 and 49 are arranged in the space under the transformer 41. This assembly mode exploits also the space under the transformer 41. In practice, components 47, 48 and 49 are firstly assembled with SMD technology on the board 43 followed by the transformer 41.

Figs. 9 and 10 illustrate a different inductive component made with element 1. In this case, a toroid shaped ferromagnetic core 51 is arranged around the collar 13. The axis of the ferromagnetic core 51 coincides with the axis A-A of the collar 13. A winding 53 made of appropriately isolated conductive wire is formed around the ferromagnetic core 51 and the turns of this winding encompass the collar 13 and a portion of the base 3, as clearly shown in Fig. 10, in addition to the ferromagnetic core 51.

The inductor thus made, generally indicated by reference numeral 55, can be fitted on an electronic board which is similar to board 43, according to one of the assembly methods illustrated in Figs. 7 and 8, after possibly cutting the terminals 9 and bending their distal ends.

Transformers can also be made with the toroid shaped ferromagnetic core 51, by turning two or more windings around the core.

As clearly appears in Fig. 9, the inductor 55 can easily be fitted on an electronic board 43 by means of an SMD assembly system because there are no problems of planarity of the winding 53, which does not come into contact with the electronic board 43 (this similarly applies to a transformer made with the same configuration). This is because, regardless of the inductive electronic component made with the element 1, the high thickness of the lateral appendixes 5 and the particular arrangement of the electric connection terminals 9 ensure that the component is always correctly fitted on the board using SMD systems, without problems deriving from possible geometric irregularities of the various portions which form the inductive component.

The particular configuration of the element 1 is consequently used to make different types of inductive components and fit them according to a variety of configurations. With reference to this, it is important to notice that the terminals 9 can be bent inwards, i.e. under the inductive component, instead of outside the plan clearance of the component, as shown by the two examples in Figs. 7 and 8. This is possible specifically when the inductive component is fitted at a certain distance with respect to the electronic board 43, as shown in the example in Fig. 8, to avoid soldering problems.

The space required in total for assembling the inductive component is reduced by bending the terminals 9 inwards.

The ends of the terminals 9 opposite to the ends which form the pins for soldering to the electronic board 43 can be shaped as illustrated in the drawing or may have a different conformation, e.g. with eyelet, to facilitate the electric connection with the windings of the inductive component, when such windings are made with a conductive wire (as in the example of the component in Figs 9 and 10) instead of a laminar conductor (as in the example of the component in Figs 4 and 5).

It is understood that the drawing shows only a simplification provided by way of a practical demonstration of the invention, the form and dimensions of said invention being able to vary without thereby departing from the scope of the idea underlying said invention. The possible presence of reference numerals in the annexed claims has the only purpose of facilitating reading of the claims with reference to the preceding description and the attached drawings and does not limit the scope of protection represented by the claims.

## Claims

1. An isolating material element (1) for the assembly of inductive electronic components, **characterised in that** it comprises a base (3) with two lateral appendixes (5) equipped with through-holes (7) for the insertion of electric connection terminals (9) and a central through aperture (11), a collar (13) developing from said base and surrounding said aperture.

2. Element according to claim 1, **characterised in that** said aperture (11) is circular and said collar (13) has a circular transversal cross-section.

3. Element according to claim 1 or 2, **characterised in that** said lateral appendixes (5) are thicker than the rest of the base and define corresponding steps (5A) projecting from said base from the opposite surface with respect to that on which said collar (13) is developed.

4. Element according to one or more of the previous claims, **characterised in that** each of said lateral appendixes presents two through-holes for said terminals.

5. Element according to one or more of the previous claims, **characterised in that** said terminals present a ridge (9A) co-operating with a corresponding stop (7A) in the respective through-hole (7).

6. Element according to one or more of the previous claims, **characterised in that** said terminals present an eyelet for welding the terminals of the conductor or of the conductors forming the winding or the windings of the inductive component formed on said element.

7. Element according to one or more of the previous claims, **characterised in that** said base presents an external edge which is essentially circular from which said appendixes project.

8. An inductive electronic component comprising an element according to one or more of the previous claims, at least one electrical winding (31; 33; 53) and a ferromagnetic core (39; 51).

9. Component according to claim 8, comprising at least two windings forming a transformer with said ferromagnetic core.

10. Component according to either claim 8 or 9, in which said winding or windings and part of the electric connection terminals are encapsulated in a plastic or synthetic resin protection.

11. Component according to claim 8, 9, or 10, in which said at least one electric winding is formed by laminar windings (31; 33).

12. Component according to one or more of the claims from 8 to 11, in which said ferromagnetic core (39) externally encompasses said element and said at least one winding and presents a central column which extends through said collar and said though aperture in said base.

13. Component according to one or more of the claims from 8 to 11 in which said ferromagnetic core (51) has a toroid development and is fitted on said element (1) to surround the collar (13), said at least one winding (53) developing helically around the ferromagnetic core and the collar, the turns of the winding crossing the through aperture (11) in said base (3).
